# FASCICULE DE BREVET EUROPEEN

(11) **EP 3 482 419 B1**
(45) Date de publication et mention de la délivrance du brevet: **08.04.2020**
(21) Numéro de dépôt: 17734768.9
(22) Date de dépôt: 06.07.2017
(51) Int. Cl.: H01L 27/146

(54) **PROCÉDÉ DE FABRICATION DE PHOTODÉTECTEUR COMPRENANT UN EMPILEMENT DE COUCHES SUPERPOSÉES**
HERSTELLUNGSVERFAHREN EINES PHOTODETEKTORS MIT GESTAPELTEN SCHICHTEN
FABRICATION PROCESS OF A PHOTODETECTOR WITH STACKED LAYERS

(30) Priorité: 08.07.2016 FR 1601066
(43) Date de publication de la demande: 15.05.2019
(73) Titulaire: Thales, 92400 Courbevoie (FR); Commissariat à l'Energie Atomique et aux Energies Alternatives, 75015 Paris (FR)
(72) Inventeur: REVERCHON, Jean-Luc, 91767 PALAISEAU CEDEX (FR); EVIRGEN, Axel, 91767 PALAISEAU CEDEX (FR); LE GOFF, Florian, 91767 PALAISEAU CEDEX (FR)
(74) Mandataire: Lavoix
(86) Numéro de dépôt international: PCT/EP2017/066951
(87) Numéro de publication internationale: WO 2018/007529

(56) Documents cités:
- WO-A1-2005/086236
- US-A1- 2011 156 273

## Description

La présente invention concerne un procédé de fabrication de photodétecteur comprenant un empilement de couches superposées pour imagerie infra-rouge.

L'invention se situe dans le domaine de l'imagerie infrarouge, correspondant à des longueurs d'onde comprises entre 900 nm (nanomètres) et 25 µm (micromètres). Dans ce domaine, des photodétecteurs comprenant une couche photo-absorbante en matériau semi-conducteur sont utilisés. Une couche photo-absorbante est une couche absorbant les photons appartenant à une gamme de longueurs d'onde prédéfinie.

Le courant d'obscurité est l'une des principales limitations aux performances d'un photodétecteur. Le courant présente une composante de diffusion dans les zones neutres et une composante de génération-recombinaison exacerbée dans les zones désertées. L'origine du courant d'obscurité comporte des composantes de génération-recombinaison Shockley-Read, de génération-recombinaison radiative ou de génération-recombinaison Auger avec différentes lois d'activation thermique.

Pour améliorer les performances de la structure détectrice, des couches barrières sont généralement superposées de part et d'autre de la couche d'absorption. Une couche barrière est une couche empêchant le passage des porteurs majoritaires et laissant passer les porteurs minoritaires. Elle permet de plus d'éviter la formation d'une zone de charge d'espace et limite par conséquent d'autant plus le courant d'obscurité.

De tels photodétecteurs comprenant une structure à empilement de couches, formant un circuit de détection, obtenues par épitaxie sur un substrat, comprenant une couche barrière, par exemple en arséniure-antimoniure de gallium-aluminum (AlGaAsSb), empilée sur une couche d'absorption en arséniure-antimoniure d'indium (InAsSb) sur substrat en antimoniure de gallium (GaSb), ont une température de fonctionnement de 130 K à 250 K.

Le photodétecteur comprend des contacts semi-conducteurs, chaque contact ayant une partie d'extrémité en contact avec au moins une zone de charge d'espace. Chaque contact permet de collecter un courant formé par le déplacement des porteurs de charge dans la zone de charge centrée sur ce contact.

Ainsi, une matrice de photo-détection formée de pixels est réalisée, les pixels ayant chacun une longueur et une largeur, en général égales et communément appelées « pas du pixel ».

Une méthode connue pour réaliser un tel photodétecteur utilise un assemblage à billes d'indium entre le circuit de photo-détection et un circuit de lecture en technologie silicium destiné à collecter le courant formé par le déplacement des porteurs de charge et à le transformer en signal vidéo exploitable par une chaîne de traitement d'images. L'utilisation de billes d'indium limite le pas de pixel à environ 10 µm.

Or il est souhaitable pour certaines applications de diminuer la taille du pas de pixel.

Une autre méthode d'assemblage alternative est une méthode de métallisation connue sous le nom de « loop-hole » consistant à réaliser des contacts à travers le circuit de détection. Appliquée à une structure à empilement de couches telle que décrite ci-dessus, une telle méthode nécessiterait de mettre en place une gravure à travers la couche d'absorption qui est une couche active de l'empilement. Cela engendrerait une zone de désertion latérale en l'absence de barrière le long de la zone gravée, et par conséquent un fort courant d'obscurité.

Les documents US2011156273 et WO2005086236 divulguent des exemples de procédés connus de fabrication de photodétecteurs comprenant l'empilement d'un ensemble de détection et d'un circuit de lecture reliés par des vias d'interconnexion.

L'invention a pour objet de remédier aux inconvénients précités, en proposant un procédé de fabrication de photodétecteur à empilement de couches superposées comprenant au moins une couche barrière, permettant d'atteindre des pas de pixel inférieurs à 10 µm, tout en limitant le courant d'obscurité et en permettant un fonctionnement à des températures supérieures ou égales à 150K.

A cet effet, l'invention propose, selon un premier aspect, un procédé de fabrication de photodétecteur apte à fonctionner pour la photodétection d'ondes électromagnétiques infrarouges, comprenant un empilement de couches minces superposées. Ce procédé comprend les étapes suivantes:
- obtention d'un premier ensemble de couches empilées, formant un ensemble de détection, comprenant une première couche de substrat réalisée en un premier matériau semi-conducteur de substrat, une couche photo-absorbante réalisée en un matériau semi-conducteur actif, une couche barrière réalisée en un matériau semi-conducteur de barrière et au moins une couche de contact réalisée en un premier matériau semi-conducteur de contact, et d'un deuxième ensemble de couches empilées formant un circuit de lecture, comprenant au moins une deuxième couche de substrat et une couche de multiplexage réalisée en un deuxième matériau semi-conducteur de contact,
- collage desdits premier et deuxième ensemble de couches empilées entre la couche de contact du premier ensemble et la couche de multiplexage du deuxième ensemble,
- gravure à travers ledit deuxième ensemble d'une pluralité de vias d'interconnexion,
- dopage p ou n de zones de la couche de contact du premier ensemble à travers lesdits vias d'interconnexion.

Avantageusement, le procédé de fabrication proposé permet de réduire le pas de pixel tout en permettant de maintenir des coûts de fabrication réduits.

Le procédé de fabrication de photodétecteur selon l'invention peut également présenter une ou plusieurs des caractéristiques ci-dessous, prises indépendamment ou selon toutes leurs combinaisons techniquement acceptables.

Dans l'étape de gravure, les vias d'interconnexion sont sensiblement identiques et régulièrement positionnés selon une grille de positionnement prédéterminée, de manière à former une matrice de pixels de photodétection.

Les vias d'interconnexion sont de forme cylindrique ou parallélépipédique.

Le procédé comprend une étape d'amincissement de la deuxième couche de substrat du deuxième ensemble après l'étape de collage et avant l'étape de gravure.

Le procédé comporte en outre une étape d'ajout de contacts ohmiques dans la pluralité des vias d'interconnexion.

Selon une variante, le dopage est réalisé par diffusion.

Selon une variante, le dopage est réalisé par implantation.

Le premier ensemble de couches empilées est obtenu par épitaxie sur la première couche de substrat.

Le procédé comporte, après l'étape de collage, le retrait de la première couche de substrat et l'ajout par collage d'une troisième couche de substrat de rigidification.

La couche de multiplexage du deuxième ensemble de couches est en silicium.

Le collage desdits premier et deuxième ensemble de couches empilées est réalisé par collage moléculaire.

Le circuit de lecture est un circuit de type CMOS.

D'autres caractéristiques et avantages de l'invention ressortiront de la description qui en est donnée ci-dessous, à titre indicatif et nullement limitatif, en référence aux figures annexées, parmi lesquelles :
- la figure 1 est un synoptique des principales étapes d'un procédé de fabrication de photodétecteur selon un mode de réalisation de l'invention ;
- les figures 2 à 7 sont des vues schématiques en coupe d'un exemple de photodétecteur à l'issue des étapes du procédé de la figure 1.

L'invention est décrite ci-après dans divers modes de réalisation.

Selon un premier mode de réalisation, le procédé de fabrication est destiné à réaliser un photodétecteur infrarouge à empilement de couches comprenant une couche de substrat réalisée en un premier matériau semi-conducteur, appelé premier matériau semi-conducteur de substrat, une couche photo-absorbante réalisée en un matériau semi-conducteur, appelé matériau semi-conducteur actif, une couche barrière réalisée en un matériau semi-conducteur, appelé matériau semi-conducteur de barrière et une couche contact en un matériau semi-conducteur, appelé matériau semi-conducteur de contact.

Le photodétecteur Pd fabriqué présente une gamme spectrale de fonctionnement parmi l'une des gammes spectrales suivantes : le proche infrarouge, le moyen infrarouge et le lointain infrarouge.

Une onde appartient à la gamme infrarouge si sa longueur d'onde est comprise au sens large entre 900 nm et 25 µm.

Une onde appartient à la gamme du proche infrarouge si sa longueur d'onde est comprise au sens large entre 900 nm et 3 µm.

Une onde appartient à la gamme du moyen infrarouge si sa longueur d'onde est comprise au sens large entre 3 µm et 5 µm.

Une onde appartient à la gamme du lointain infrarouge si la longueur d'onde de l'onde est comprise au sens large entre 5 µm et 25 µm.

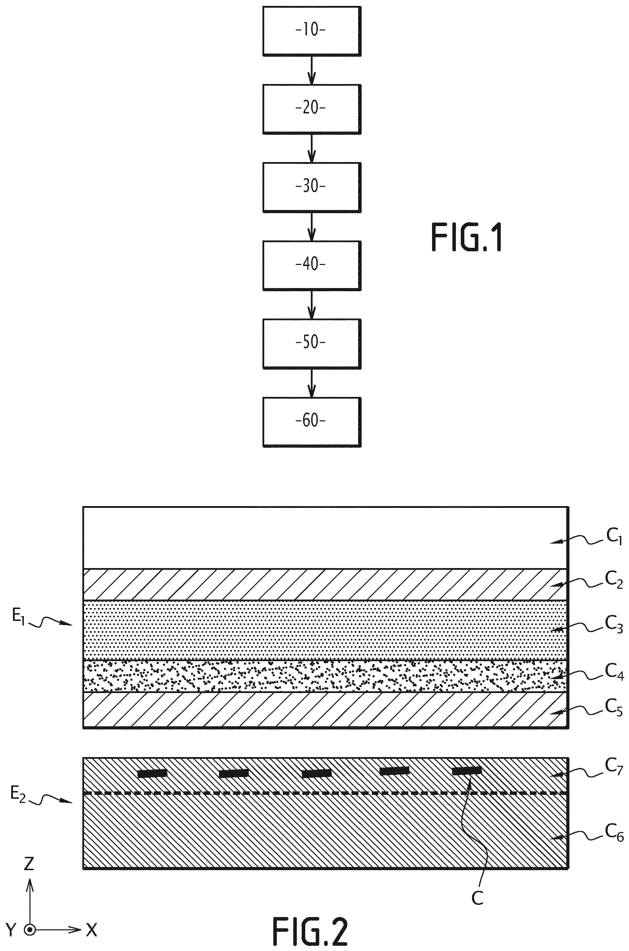

La figure 1 est un synoptique des principales étapes d'un procédé selon un mode de réalisation.

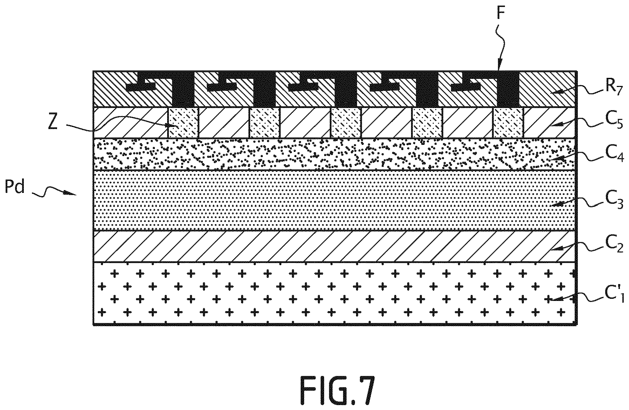

Les figures 2 à 7 illustrent des portions d'empilement de couches formées à l'issue des diverses étapes du procédé de fabrication décrit.

Un photodétecteur Pd est réalisé. Les empilements de couches sont représentées dans un repère spatial (X, Y, Z), X désignant la direction longitudinale, Y désignant la direction transversale, Z désignant la direction d'empilement.

La direction d'empilement Z correspond à une direction générale de propagation de la lumière.

Il est à noter que les illustrations des figures 2 à 7 sont schématiques et ne sont pas à l'échelle d'un photodétecteur fonctionnel.

Lors d'une première étape 10, on obtient un premier ensemble E₁ de couches empilées, formant un ensemble de détection, également appelé circuit de détection.

Un premier ensemble de couches empilées E₁ selon un mode de réalisation est illustré à la figure 2.

Dans un mode de réalisation, le premier ensemble E₁ de couches empilées comporte une couche de substrat C₁ réalisée en un premier matériau semi-conducteur de substrat, désigné par matériau M₁.

La couche de substrat C₁ est transparente dans la gamme spectrale de fonctionnement du photodétecteur Pd.

Par le terme « transparent », il est entendu que la couche absorbe moins de 10 % de la lumière incidente et appartenant à la gamme spectrale de fonctionnement du photodétecteur Pd lorsque l'épaisseur le long de la direction d'empilement Z de la couche est inférieure à la dizaine de micromètres.

Le matériau M₁ est choisi pour présenter des paramètres de maille permettant la croissance par épitaxie d'une ou de plusieurs couches cristallines sur le matériau M₁. Les paramètres de maille d'un cristal désignent, par exemple, trois longueurs et trois angles utilisés pour décrire la maille du cristal.

Le matériau M₁ est également choisi de sorte à avoir des paramètres de maille permettant d'éviter la formation de défauts cristallins lors de la croissance par épitaxie d'une ou de plusieurs couches sur le matériau M₁.

Le matériau M₁ est un matériau composé ou non. Un matériau composé est un assemblage d'au moins deux matériaux, chaque matériau étant un élément ou un alliage. Chaque matériau formant le matériau M₁ appartient à l'une des colonnes de la classification périodique des éléments parmi les colonnes suivantes : IIB, IIIA, IVA, VA et VIA. La classification périodique utilisée est la classification par numéro atomique croissant établie par Moseley au début du XX^{ème} siècle.

Le groupe II de la classification périodique est aussi appelé groupe 12. Le groupe II comprend, notamment, le zinc (Zn), le cadmium (Cd) et le mercure (Hg).

Le groupe III de la classification périodique est aussi appelé groupe 13. Le groupe III correspond au groupe du bore et comprend, notamment, le bore (B), l'aluminium (Al), le gallium (Ga) et l'indium (In).

Le groupe IV de la classification périodique est aussi appelé groupe 14. Le groupe IV comprend, notamment, le silicium (Si) et le germanium (Ge).

Le groupe V de la classification périodique est aussi appelé groupe 15 ou famille de l'azote. Le groupe V comprend, notamment, l'azote (N), le phosphore (P), l'arsenic (As) et l'antimoine (Sb).

Le groupe VI de la classification périodique est aussi appelé groupe 16. Le groupe VI comprend, notamment, l'oxygène (O), le soufre (S) et le selenium (Se).

Avantageusement, les matériaux des colonnes III et II peuvent respectivement être associés à des matériaux des colonnes V et VI pour la réalisation d'hétéro-structures pour photodétecteurs. On parlera d'alliages II-VI ou III-V.

Le matériau M₁ est, par exemple, l'arséniure de gallium (GaAs), le phosphure d'indium (InP), l'antimoniure d'indium (InSb), ou l'antimoniure de gallium (GaSb). L'arséniure de gallium et l'antimoniure de gallium présentent l'avantage d'être des matériaux à gap direct. Un matériau à gap direct est un matériau privilégié pour émettre de la lumière à la suite d'une recombinaison électron-trou.

Optionnellement, dans le cas où le matériau M₁ n'est pas l'antimoniure de gallium, une couche tampon additionnelle est superposée sur la première couche de substrat C₁. La couche tampon additionnelle permet de rapprocher le matériau M₁ de l'accord de maille sur l'antimoniure de gallium.

Le matériau M₁ présente un premier gap (ou largeur de bande interdite) E_{g}¹.

La couche de substrat C₁ a une épaisseur z₁ le long de la direction d'empilement Z, comprise au sens large entre 300 µm et 900 µm avant amincissement puis entre 300 nm et 10 µm après amincissement. En outre, le dopage du substrat est choisi pour optimiser sa qualité et sa transparence.

Le premier ensemble E₁, comporte, empilée sur la couche de substrat C₁, ou, le cas échéant, sur la couche tampon additionnelle, une couche d'interface C₂, en un matériau semi-conducteur M₂, appelé ici matériau semi-conducteur d'interface.

Cette couche d'interface C₂ a une épaisseur z₂ le long de la direction d'empilement Z, comprise au sens large entre 50 nm et 1 µm. Son rôle est d'assurer un bon contact électrique commun tout en limitant la génération de courant d'obscurité.

Le matériau semi-conducteur M₂ est dopé n ou p.

Il est entendu par le terme « dopage n », l'introduction d'impuretés dans un semi-conducteur de sorte à produire un excès d'électrons. Il est entendu par le terme « dopage p », l'introduction d'impuretés dans un semi-conducteur de sorte à produire un déficit d'électrons.

La couche d'interface C₂ présente un deuxième gap E_{g}² inférieur au premier gap E_{g}¹ du premier matériau semi-conducteur de substrat.

Une couche active C₃, qui est photo-absorbante, est empilée sur la couche d'interface C₂. Dans la suite de la description, il est entendu par l'expression « couche photo-absorbante », une couche absorbant au moins 10%, et de préférence au moins 50%, des photons appartenant à la gamme spectrale de fonctionnement du photodétecteur Pd et arrivant sur la couche photo-absorbante.

La couche photo-absorbante C₃ est réalisée en un matériau semi-conducteur, appelé ici matériau semi-conducteur actif, désigné par matériau M₃

Le matériau M₃ est choisi pour être en accord de maille avec le matériau M₂ de la couche d'interface C₂, le matériau M₂ étant lui-même en accord de maille avec le matériau M₁ sauf quand une couche tampon additionnelle est utilisée.

Le matériau M₃ est un matériau composé ou non. Chaque matériau formant le matériau M₃ appartient à l'une des colonnes de la classification périodique parmi les colonnes suivantes : IIB, IIIA, VA et VIA. Avantageusement, le matériau M₃ est un alliage II-VI ou III-V.

Le matériau M₃ est dopé n ou p.

Le taux de dopage du matériau M₃ est compris au sens large entre 10¹⁴ cm⁻³ et 10¹⁸ cm⁻³. Le taux de dopage est défini comme le nombre de dopants dans un centimètre cube du réseau cristallin. Le taux de dopage est volumique.

Lorsque le matériau M₃ est dopé n ou p, le matériau M₂ est, par exemple, choisi parmi : l'arséniure-antimoniure d'indium (InAsSb), des alliages digitaux d'arséniure-antimoniure d'indium et d'arséniure d'indium et des super-réseaux d'arséniure d'indium et d'antimoniure de gallium.

Un super-réseau est un empilement périodique de couches de faibles épaisseurs permettant de générer un matériau de gap différent des matériaux d'origine. Un alliage digital est un super-réseau avec des couches de périodes suffisamment fines pour que les porteurs soient insensibles à la structuration.

Le matériau M₃ présente un troisième gap E_{g}³, inférieur au premier gap E_{g}¹ de la couche de substrat C₁ et inférieur au deuxième gap E_{g}² de la couche d'interface C₂.

La couche photo-absorbante C₃ présente une épaisseur z₃ le long de la direction d'empilement Z, qui est de l'ordre de grandeur de la longueur optique d'absorption d'un photon. La longueur optique d'absorption d'un photon dans un matériau donné est le chemin optique parcouru par le photon dans le matériau avant que le photon soit absorbé dans le matériau suivant une loi d'absorption exponentielle telle que la loi de Beer-Lambert. Plus précisément, l'épaisseur z₃ est comprise au sens large entre 100 nm et 20 µm.

Le premier ensemble E₁ comporte, en contact avec la couche photo-absorbante C₃, une couche barrière C₄.

Dans la suite de la description, il est entendu par l'expression « couche barrière», une couche formant une barrière de potentiel sur la bande de valence pour bloquer les trous ou sur la bande de conduction pour bloquer les électrons.

La couche barrière C₄ est transparente dans la gamme spectrale de fonctionnement du photodétecteur Pd.

La couche barrière C₄ est réalisée en un matériau semi-conducteur dit matériau semi-conducteur de barrière, désigné par matériau M₄.

Le matériau M₄ est choisi pour être en accord de maille avec le matériau M₃ ou en quasi accord de maille dans le cas où le matériau M₃ est l'arséniure-antimoniure de gallium-aluminium (AlGaAsSb). L'expression « quasi-accord de maille » signifie un désaccord de maille de moins de 0,05%.

Le matériau M₄ est un matériau composé ou non. Chaque matériau formant le matériau M₄ appartient à l'une des colonnes de la classification périodique parmi les colonnes suivantes : IIB, IIIA, VA et VIA. Avantageusement, le matériau M₄ est un alliage II-VI ou III-V.

Le matériau M₄ est faiblement dopé ou non dopé. En particulier, le matériau M₄ est non dopé ou faiblement dopé n lorsque le matériau M₃ est dopé n et est non dopé ou faiblement dopé p lorsque le matériau M₃ est dopé p.

Le taux de dopage du matériau M₄ est compris au sens large entre 10¹³ cm⁻³ et 10¹⁸ cm⁻³.

Lorsque le matériau M₃, de préférence InAsSb, est dopé n, le matériau M₄ est, par exemple, choisi parmi : l'antimoniure de gallium-aluminium (AIGaSb) et l'arséniure-antimoniure de gallium-aluminium (AlGaAsSb). Dans ce cas, le matériau M₄ présente une forte discontinuité de bande de conduction permettant de bloquer les électrons.

Lorsque le matériau M₃ est dopé p, le matériau M₄ est, par exemple, l'antimoniure de gallium.

Le matériau M₄ présente un quatrième gap E_{g}⁴. Le quatrième gap E_{g}⁴ est supérieur au sens strict au troisième gap E_{g}³ de la couche photo-active C₃.

La couche barrière C₄ a une épaisseur z₄ le long de la direction d'empilement Z, comprise au sens large entre 30 nm et 1 µm.

Enfin, le premier ensemble E₁ comprend une couche de contact C₅, en un matériau semi-conducteur dit matériau semi-conducteur de contact, désigné par matériau M₅.

Cette couche de contact C₅ a une épaisseur z₅ le long de la direction d'empilement Z, comprise au sens large entre 10 nm et 1 µm. Le matériau M₅ de la couche C₅ est choisi de manière à permettre une bonne passivation électrique de surface.

Le premier ensemble E₁ de couches empilées est réalisé par épitaxie sur la couche de substrat C₁.

Ce premier ensemble E₁ a une épaisseur totale *zₜₒₜ* le long de la direction d'empilement Z comprise entre 1 et 10 µm.

Voici quelques exemples non exhaustifs de matériaux utilisables respectivement pour la couche d'interface C₂ et pour la couche photo-absorbante C₃ pour la réalisation d'un ensemble de détection E₁ décrit ci-dessus.

Pour un fonctionnement dans le proche infrarouge ou SWIR (pour « short wave infrared ») :
- matériau M₃: arséniure d'indium gallium (InGaAs), matériau M₂: phosphure d'indium (InP) ;
- matériau M₃: silicium germanium (SiGe) ou germanium (Ge), matériau M₂: silicium.

Pour un fonctionnement dans le moyen infrarouge ou MWIR (pour « medium wave infrared ») :
- matériau M₃: arséniure-antimoniure d'indium (InAsSb), ou arséniure d'indium (InAs), matériau M₂ de formule AlₓGa₍₁₋ₓ₎As_{y}Sb_{(1-y)}, avec x égal à 0 ou à 1, y égal à 0 ou à 1 ;
- matériau M₃: antimoniure d'indium (InSb), matériau M₂ : antimoniure d'indium aluminium (InAlSb).

Pour un fonctionnement dans le lointain infrarouge ou LWIR (pour « long wave infrared ») :
- matériau M₃:l'antimoniure de gallium (GaSb) ou l'arséniure d'indium (InAs), matériau M₂ de formule AlₓGa₍₁₋ₓ₎As_{y}Sb_{(1-y)}, avec x égal à 0 ou à 1, y égal à 0 ou à 1.

Lors de la première étape 10 du procédé on obtient également un deuxième ensemble de couches empilées E₂, formant un circuit de lecture, destiné à permettre de collecter le courant formé par le déplacement des porteurs de charge dans l'ensemble de détection E₁.

Dans un mode de réalisation, le deuxième ensemble E₂ est un circuit de type CMOS (« *complementary metal oxide semiconductor* ») comprenant une couche de substrat C₆, qui est une deuxième couche de substrat, réalisée en un matériau semi-conducteur appelé deuxième matériau semi-conducteur de substrat et désigné par matériau M₆.

Le deuxième ensemble E₂ comporte également une couche de multiplexage C₇, qui comprend un ensemble de contacts métalliques C et qui implémente des fonctionnalités électriques d'un circuit CMOS, en particulier des transistors.

Le matériau semi-conducteur M₆ est par exemple le silicium (Si).

La couche de substrat C₆ a une épaisseur z₆ dans la direction d'empilement d'une ou plusieurs centaines de micromètres, par exemple d'environ 600 µm.

La couche de multiplexage C₇ est en un deuxième matériau semi-conducteur de contact, désigné par matériau M₇. Dans un mode de réalisation, le matériau M₇ est du silicium dans lequel des fonctionnalités de multiplexage sont implémentées (circuit CMOS).

En variante, il est possible d'utiliser d'autres matériaux que du silicium pour implémenter des fonctionnalités électriques d'un circuit de lecture.

Chaque élément de contact C est en un matériau métallique, par exemple aluminium ou cuivre, adapté aux fonderies silicium, en particulier adapté à la technologie CMOS.

La première étape 10 du procédé de fabrication est suivie d'une étape 20 de collage du premier ensemble E₁ et du deuxième ensemble E₂, effectué entre la couche de contact C₅ du premier ensemble E₁ et la couche de contact C₇ du deuxième ensemble E₂.

Dans un mode de réalisation, le collage est un collage moléculaire, effectué par double encapsulation silice /silice.

En variante, tout autre type de collage moléculaire est envisageable, par exemple : SiN / SiN, SiOx/SiOx, Polymère (BCB), SiN / semiconducteur, SiOx / semiconducteur, Métal / métal.

Selon une variante optionnelle, l'étape 20 comporte également le retrait de la première couche de substrat C₁ et son remplacement par une couche de substrat rigidifiée C'₁, d'épaisseur z'₁ selon la direction d'empilement Z, l'épaisseur z'₁ étant légèrement supérieure à l'épaisseur z₁ de la première couche de substrat C₁.

La couche de substrat rigidifiée est en un matériau adapté à la tenue mécanique et aux procédés technologiques, par exemple en silicium, ou tout autre matériau rigide utilisé dans les procédés technologiques de fabrication industrielle de circuits intégrés.

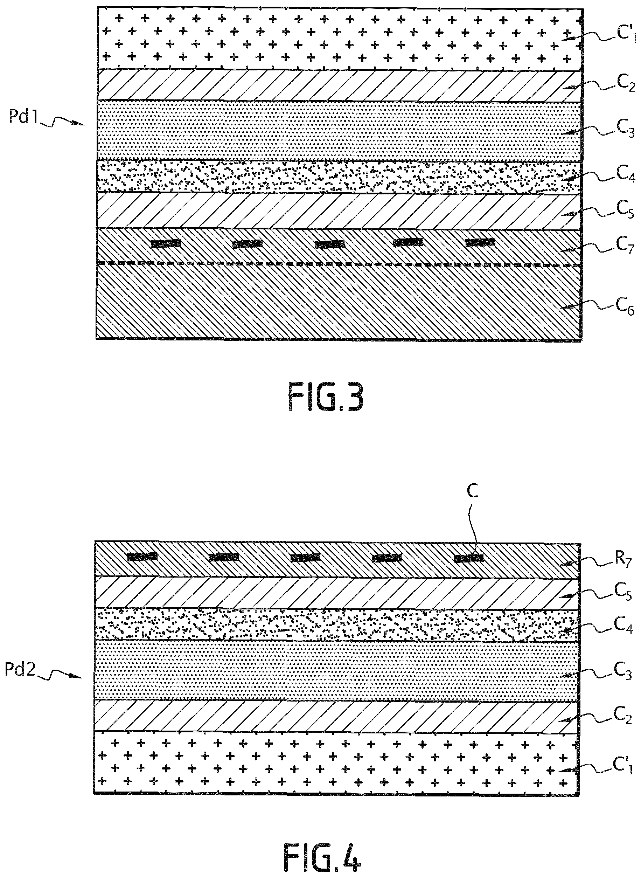

A l'issue de l'étape 20 de collage on obtient une structure d'empilement de couches minces notée Pd1, telle qu'illustrée schématiquement à la figure 3.

L'étape de collage 20 est suivie d'une étape 30 d'amincissement consistant à amincir ou éliminer la couche de substrat C₆ provenant du deuxième ensemble E₂.

Par exemple, la technologie d'amincissement smart-cut® est appliquée pour réduire l'épaisseur de cette couche de substrat C₆.

Par exemple, dans un mode de réalisation, la couche de substrat C₆ a une épaisseur z₆ dans la direction d'empilement d'environ 600 µm initialement, et après l'étape d'élimination et d'amincissement 30 l'épaisseur de cette couche de substrat est de l'ordre de 5 µm, de préférence inférieure à 10µm.

La partie restante du deuxième ensemble E₂ à l'issue de l'étape 30 est notée R₇.

La partie restante R7 comprend au moins la couche de multiplexage C₇ du deuxième ensemble E₂.

La figure 4 illustre une structure d'empilement de couches minces notée Pd2 obtenue à l'issue de l'étape 30, dans laquelle la couche de substrat C₆ a été éliminée à l'étape d'amincissement 30.

L'étape d'amincissement 30 est suivie d'une étape 40 de gravure de conduits d'interconnexion D, appelés également vias d'interconnexion, à travers la partie restante R₇ du deuxième ensemble E₂ après l'étape d'amincissement 30.

La gravure est effectuée selon l'axe d'empilement Z.

Chaque via d'interconnexion D a une profondeur sensiblement égale à l'épaisseur de la partie restante R₇ du deuxième ensemble E₂ après l'étape d'amincissement 30.

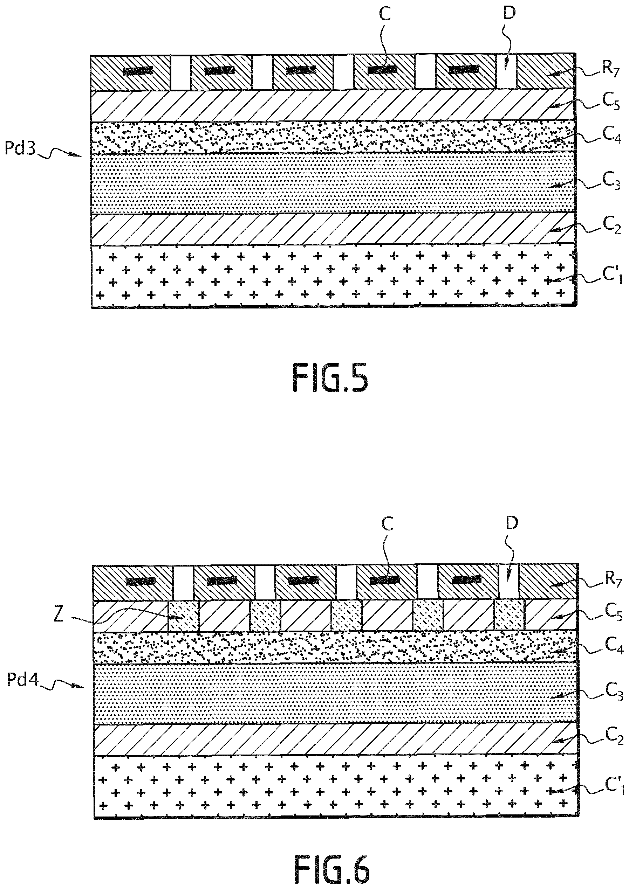

Les vias d'interconnexion D sont sensiblement identiques et régulièrement positionnés selon une grille de positionnement prédéterminée, de manière à former une matrice de pixels de photodétection. De tels vias d'interconnexion D sont illustrés sur la figure 5.

Dans un mode de réalisation, les vias d'interconnexion D sont cylindriques, de diamètre compris entre 50 nm et 5 µm.

En variante, chaque via d'interconnexion D a la forme d'un parallélépipède. Par exemple, chaque via d'interconnexion D présente une longueur dans la direction longitudinale X comprise au sens large entre 50 nm à 5 µm et une largeur dans la direction transversale Y comprise au sens large entre 50 nm à 5 µm.

L'étape 40 de formation des vias d'interconnexion D est suivie d'une étape 50 de dopage à travers les vias d'interconnexion D et la couche de contact C₅.

Le dopage est soit un dopage p, soit un dopage n.

Le dopage est effectué avec un taux de dopage, compris au sens large entre 10¹⁵ cm⁻³ et 10²⁰ cm⁻³.

Le dopage est effectué par diffusion ou par implantation.

La diffusion de dopant: mécanisme de migration d'un élément dopant dans un matériau cristallin. Le front de diffusion est dirigé d'une phase riche à la surface du matériau vers l'intérieur de celui-ci. Lorsque le milieu hôte est de type opposé à celui du dopant, la diffusion permet ainsi de former une jonction semi-conductrice p-n.

Le dopage par implantation consiste en un bombardement d'ions accélérés, permettant l'insertion contrôlée des éléments dans la maille, qui après un recuit de guérison deviennent des dopants. La nature des dopants est choisie opposée à celle du semi-conducteur dans lequel a lieu l'implantation créant ainsi une jonction semi-conductrice p-n.

Le dopage permet de générer des zones Z dopées, chaque zone Z étant sensiblement centrée autour d'un via d'interconnexion D correspondant. De telles zones Z sont illustrées à la figure 6.

L'étape de dopage 50 est également appelée étape de pixellisation, car elle permet de générer des zones de photodétection où le courant est collecté grâce aux vias d'interconnexion D, permettant de former des pixels de photodétection. Les pixels sont indépendants et isolés les uns des autres.

Enfin, l'étape de pixellisation 50 est suivie d'une étape 60 de finalisation de la connectique, consistant à former des contacts ohmiques F entre les zones Z dopées et éléments de contact C de la couche de contact C₇, à travers les canaux d'interconnexion D.

Par exemple, les vias d'interconnexion D sont remplis d'un matériau métallique, par exemple par pulvérisation.

De préférence, on utilise le matériau métallique utilisé pour les contacts C, par exemple titane, platine ou or, adapté à réaliser un contact ohmique.

Les contacts F ainsi réalisés permettent la lecture d'un courant associé à chaque zone dopée Z, et donc d'un signal électrique associé à chaque pixel de la matrice de pixels de photodétection.

Ainsi, le photodétecteur final Pd est obtenu à l'issue de l'étape 60 de finalisation de la connectique.

Avantageusement, lorsque le premier ensemble E₁ comprend une couche photo-absorbante en arséniure-antimoniure d'indium (InAsSb) sur une couche substrat en antimoniure de gallium (GaSb), la température de fonctionnement du photodétecteur sera supérieure ou égale à 150 K.

De plus, avantageusement, la fourniture séparée du premier ensemble de détection E₁ et du deuxième ensemble de lecture E₂ permet une fabrication selon des procédés de fabrication optimisés pour chacun de ces ensembles. Le procédé de fabrication effectué en parallèle sur un grand nombre d'imageurs, et par conséquent les coûts de production de photodétecteurs sont réduits.

Avantageusement, l'amincissement de la couche de substrat du circuit de lecture permet de réaliser une matrice de photodétection de pas pixel réduit et inférieur à 10 µm.

## Revendications

1. Procédé de fabrication de photodétecteur apte à fonctionner pour la photodétection d'ondes électromagnétiques infrarouges, comprenant un empilement de couches minces superposées, **caractérisé en ce qu'**il comprend les étapes suivantes:
- obtention (10) d'un premier ensemble (E₁) de couches empilées, formant un ensemble de détection, comprenant une première couche de substrat (C₁) réalisée en un premier matériau semi-conducteur de substrat, une couche photo-absorbante (C₃) réalisée en un matériau semi-conducteur actif, une couche barrière (C₄) réalisée en un matériau semi-conducteur de barrière et au moins une couche de contact (C₅) réalisée en un premier matériau semi-conducteur de contact, et
d'un deuxième ensemble (E₂) de couches empilées formant un circuit de lecture, comprenant au moins une deuxième couche de substrat (C₆) et une couche de multiplexage (C₇) réalisée en un deuxième matériau semi-conducteur de contact,
- collage (20) desdits premier et deuxième ensemble de couches empilées entre la couche de contact (C₅) du premier ensemble (E₁) et la couche de multiplexage (C₇) du deuxième ensemble (E₂),
- gravure (40) à travers ledit deuxième ensemble d'une pluralité de vias d'interconnexion (D),
- dopage (50) p ou n de zones (Z) de la couche de contact du premier ensemble à travers lesdits vias d'interconnexion (D).

2. Procédé selon la revendication 1, dans lequel dans l'étape de gravure, lesdits vias d'interconnexion (D) sont sensiblement identiques et régulièrement positionnés selon une grille de positionnement prédéterminée, de manière à former une matrice de pixels de photodétection.

3. Procédé selon l'une des revendications 1 ou 2, dans lequel lesdits vias d'interconnexion (D) sont de forme cylindrique ou parallélépipédique.

4. Procédé selon l'une des revendications 1 à 3, comprenant une étape d'amincissement (30) de la deuxième couche de substrat du deuxième ensemble après l'étape de collage et avant l'étape de gravure.

5. Procédé selon l'une des revendications 1 à 4, comportant en outre une étape d'ajout (60) de contacts ohmiques (F) dans la pluralité des vias d'interconnexion (D).

6. Procédé selon l'une des revendications 1 à 5, dans lequel le dopage est réalisé par diffusion.

7. Procédé selon l'une des revendications 1 à 5, dans lequel le dopage est réalisé par implantation.

8. Procédé selon l'une des revendications 1 à 7, dans lequel ledit premier ensemble (E₁) de couches empilées est obtenu par épitaxie sur la première couche de substrat.

9. Procédé selon l'une des revendications 1 à 8, comportant, après l'étape de collage (20), le retrait de la première couche de substrat (C₁) et l'ajout par collage d'une troisième couche (C'₁) de substrat de rigidification.

10. Procédé selon l'une des revendications 1 à 9, dans lequel la couche de multiplexage (C₇) du deuxième ensemble de couches est en silicium.

11. Procédé selon l'une des revendications 1 à 10, dans lequel ledit circuit de lecture est un circuit de type CMOS.

## Patentansprüche

1. Verfahren zur Herstellung eines Photodetektors, der imstande ist, für die Photodetektion elektromagnetischer Infrarotwellen zu funktionieren, umfassend einen Stapel übereinanderliegender Dünnschichten, **dadurch gekennzeichnet, dass** es die folgenden Schritte umfasst:
- Erhalten (10) einer ersten Einheit (E₁) gestapelter Schichten, die eine Detektionseinheit bilden, umfassend eine erste Substratschicht (C₁), hergestellt aus einem ersten Substrat-Halbleitermaterial, eine Photoabsorptionsschicht (C₃), hergestellt aus einem aktiven Halbleitermaterial, eine Barriereschicht (C₄), hergestellt aus einem Barriere-Halbleitermaterial und mindestens eine Kontaktschicht (C₅), hergestellt aus einem ersten Kontakt-Halbleitermaterial, und
einer zweiten Einheit (E₂) gestapelter Schichten, die eine Leseschaltung bilden, umfassend mindestens eine zweite Substratschicht (C₆) und eine Multiplexschicht (C₇), hergestellt aus einem zweiten Kontakt-Halbleitermaterial,
- Verkleben (20) der ersten und zweiten Einheit gestapelter Schichten zwischen der Kontaktschicht (C₅) der ersten Einheit (E₁) und der Multiplexschicht (C₇) der zweiten Einheit (E₂),
- Gravieren (40), durch die zweite Einheit, einer Vielzahl von Verbindungs-Vias (D),
- p- oder n-Dotieren (50) von Zonen (Z) der Kontaktschicht der ersten Einheit durch die Verbindungs-Vias (D).

2. Verfahren nach Anspruch 1, wobei bei dem Gravurschritt die Verbindungs-Vias (D) etwa identisch und gemäß einem Positionierungsgitter gleichmäßig positioniert sind, so dass sie eine Photodetektionspixelmatrix bilden.

3. Verfahren nach einem der Ansprüche 1 oder 2, wobei die Verbindungs-Vias (D) zylindrisch oder parallelepipedisch geformt sind.

4. Verfahren nach einem der Ansprüche 1 bis 3, umfassend einen Verschlankungsschritt (30) der zweiten Substratschicht der zweiten Einheit nach dem Klebeschritt und vor dem Gravurschritt.

5. Verfahren nach einem der Ansprüche 1 bis 4, umfassend ferner einen Schritt des Hinzufügens (60) von ohmschen Kontakten (F) zu der Vielzahl von Verbindungs-Vias (D).

6. Verfahren nach einem der Ansprüche 1 bis 5, wobei das Dotieren durch Diffusion durchgeführt wird.

7. Verfahren nach einem der Ansprüche 1 bis 5, wobei das Dotieren durch Implantation durchgeführt wird.

8. Verfahren nach einem der Ansprüche 1 bis 7, wobei die erste Einheit (E₁) gestapelter Schichten durch Epitaxie auf der ersten Substratschicht erhalten wird.

9. Verfahren nach einem der Ansprüche 1 bis 8, aufweisend, nach dem Gravurschritt (20), das Entfernen der ersten Substratschicht (C₁) und das Hinzufügen durch Kleben einer dritten versteifenden Substratschicht (C'₁).

10. Verfahren nach einem der Ansprüche 1 bis 9, wobei die Multiplexschicht (C₇) der zweiten Schichteinheit aus Silizium ist.

11. Verfahren nach einem der Ansprüche 1 bis 10, wobei die Leseschaltung eine Schaltung vom Typ CMOS ist.

## Claims

1. A method for manufacturing a photodetector able to operate for the photodetection of infrared electromagnetic waves, comprising a stack of thin layers placed on top of one another, **characterized in that** it comprises the following steps:
- obtaining (10) a first assembly (E₁) of stacked layers, forming a detection assembly, comprising a first substrate layer (C₁) made from a first semiconducting substrate material, a photoabsorbent layer (C₃) made from an active semiconductor material, a barrier layer (C₄) made from a semiconductor barrier material and at least one contact layer (C₅) made from a first semiconductor contact material, and
a second assembly (E₂) of stacked layers forming a reading circuit, comprising at least one second substrate layer (C₆) and a multiplexing layer (C₇) made from a second semiconductor contact material,
- gluing (20) said first and second assembly of stacked layers between the contact layer (C₅) of the first assembly (E₁) and the multiplexing layer (C₇) of the second assembly (E₂),
- etching (40) through said second assembly of a plurality of interconnect vias (D),
- p or n doping (50) of zones (Z) of the contact layer of the first assembly through said interconnect vias (D).

2. The method according to claim 1, wherein in the etching step, said interconnect vias (D) are substantially identical and regularly positioned in a predetermined positioning grid, so as to form a matrix of photodetection pixels.

3. The method according to any one of claims 1 or 2, wherein said interconnect vias (D) are cylindrical or parallelepiped.

4. The method according to one of claims 1 to 3, comprising a step for thinning (30) of the second substrate layer of the second assembly after the gluing step and before the etching step.

5. The method according to one of claims 1 to 4, further comprising a step for adding (60) ohmic contacts (F) in the plurality of interconnect vias (D).

6. The method according to any one of claims 1 to 5, wherein the doping is done by diffusion.

7. The method according to any one of claims 1 to 5, wherein the doping is done by implantation.

8. The method according to one of claims 1 to 7, wherein the first assembly (E₁) of stacked layers is obtained by epitaxy on the first substrate layer.

9. The method according to one of claims 1 to 8, including, after the gluing step (20), removing the first substrate layer (C₁) and adding, by gluing, a third stiffening substrate layer (C'₁).

10. The method according to one of claims 1 to 9, wherein the multiplexing layer (C₇) of the second assembly of layers is made from silicon.

11. The method according to one of claims 1 to 10, wherein the reading circuit is a circuit of the CMOS type.
